# EUROPEAN PATENT SPECIFICATION

(11) **EP 0 546 060 B1**
(45) Date of publication and mention of the grant of the patent: **29.12.1997**
(21) Application number: 91916282.6
(22) Date of filing: 20.08.1991
(51) Int. Cl.: H05K 7/14

(54) **PROCESS INTERFACE SYSTEM**
SCHNITTSTELLENEINRICHTUNG FÜR AUTOMATISIERUNGSGERÄT
SYSTEME D'INTERFACE POUR PROCESSUS INDUSTRIELS

(30) Priority: 29.08.1990 SE 9002763
(43) Date of publication of application: 16.06.1993
(73) Proprietor: ASEA BROWN BOVERI AB, 721 83 Västeras (SE)
(72) Inventor: FRIDHOLM, Kenneth, S-723 55 Västeras (SE); LILJEGREN, Lars, S-724 63 Västeras (SE)
(86) International application number: SE9100547
(87) International publication number: WO9204813

(56) References cited:
- EP-A- 0 227 028
- FI-B- 76 235

## Description

### TECHNICAL FIELD

The invention relates to electronic units for interface between transducers or actuators and supervisory equipment, for example a computer, preferably for use in a process control system.

### BACKGROUND ART

In connection with the monitoring of industrial processes, different types of computerized control systems are used. The task of a central computer is then to monitor and control the process. This is done by programming the computer with instructions about the course of the process. For the monitored computer to be able to provide control signals to the process, the computer must also be informed of current states and events in the process, which is achieved by transducers and actuators conveying such information to the computer ; (see e.g. EP-A-0 227 028).

The transducers, actuators or other members, with which the control computer of the process communicates, usually impose quite different demands on signals for their communication with the computer with respect to voltage and current levels as well as types of signals. Both analog and digital signal types are used. For interface of signals between the computer and all variants of external members in the process which are connected to the computer, interface units are utilized. These interface units usually consist of printed circuit boards (PCBs) provided with electronics which convert and adapt signals to the needs of the receiver members (A PCB populated with electronics is a circuit board (CB).)

Interface CBs according to the above are often necessary to adapt electrical signals from transducers/actuators to the computer or vice versa. The signals which are fed from transducers/actuators into the computer may be of both analog and digital kind and must then be adapted to signals relevant to the computer, and in the same way output signals from the computer may need to be converted into signals which are relevant to the connected equipment in analog or digital form. In this connection, the designations AI/AO are used for analog input and output signals, respectively, and DI/DO for digital input and output signals, respectively. Adaptation of current and voltage levels between transducers/actuators and computer may also be necessary.

When designing electronic equipment based on the use of PCBs in flexible systems, it is nowadays common for PCBs to be mounted in cubicles or boxes with cubicle frames. CBs with different functions are built together into larger units by inserting the PCBs into the cubicle frames into slots intended for the PCBs. Communication with the respective CB is possible by the connection of buses to the CB. Such bus connection may be utilized both for internal communication between different CBs and for system communication between CBs and the computer.

When using the above technique in, for example, process computer systems, the transducers/actuators are to be connected to different interface CBs in the process computer system. Normally, this connection is arranged by placing an optional number of terminal blocks in rows adjacent the PCBs on the cubicle frames. These terminal blocks function as connection and distribution terminal blocks, to which external members are connected by cross-interconnection (also called marshalling).

Cross-interconnection means, for example, that the strands in a multi-conductor cable are connected in the proper order, determined by how the cable strands are placed in a cable, to a row of terminal blocks. To another row of terminal blocks there is connected the cabling from a process interface CB in a sequence determined by how the process interface CB is organized. Between these two rows of terminal blocks the cross-interconnection is then carried out. This is often located in a cubicle adjacent to the process interface units. A similar cross-interconnection is often used adjacent to the transducers, to be able to connect the connection points of the transducers to a multi-conductor cable.

Voltage supply or other supply of CBs, transducers or other units in the system can also be arranged by the use of the terminal blocks as contact and connection devices.

When designing a specific electronic system, such as a process computer system for a certain industrial process, a control computer is utilized which is connected to interface equipment. This interface equipment is usually built into a cubicle with cubicle frames according to the above and is normally placed at the side of the process. System equipment in the form of interface units, that is, CBs intended for signal and system interface, is located in the cubicle. Between the computer and the interface units, information is conveyed in buses. The distance between the system cubicle and the transducers/actuators in the process may vary considerably. Normally, signal cabling is used, the signal being directly transmitted between the transducer and the interface unit, often in a multi-conductor cable via one or more cross-interconnections. However, in case of longer distances, the process interface CBs, or special process interface units, may instead be located in the vicinity of the transducers/actuators, whereupon the process signals are transmitted in coded form via a serial bus, for example with the aid of a modem.

The above-mentioned terminal blocks are normally fixed to the cubicle frames on mounting rails in the form of metal rails, provided with flanges, to which the terminal blocks are normally snapped by means of snap-in members below the terminal block. Terminal blocks are then placed in rows side-by-side on the mounting rail. Profiles are available in standard designs, for example according to the DIN standard EN 50 022 or EN 50 035.

The CBs or PCB-based electronic units which constitute the interface units in the system are normally of multi-channel design, that is, several signal communication channels are realized on the same PCB. This may entail several disadvantages. Some of these are listed below:
- In case of a fault in one channel, also other channels on the same CB are affected, since an entire CB must be replaced or repaired;
- The configuration of the CBs using conventional technique means that they can only handle one or few types of signals, and therefore many different types of standard CBs must be kept in stock;
- Many types of CBs must be placed close to each other since they are connected to a parallel bus for communication with the computer, which entails increased costs since they cannot therefore be placed immediately adjacent to the transducers and the actuators;
- Conventional technique entails high costs for each channel if advanced programming and diagnostic functions with respect to connection of different signals levels are introduced;
- Easily destructible, since normally the cost becomes too high with sufficient protective means, implemented by conventional standard IC-based technique;
- It is not possible to design a CB which fits every externally connected object;
- Some channels may not be utilized in each installed CB.

Connection between external members and interface CBs through direct connection of the transducer via a multi-conductor cable and cross-interconnection has been mentioned above. In the case of very large industrial processes, many channels are utilized for communicaton between the computer and the external members. This provides a low cost for the interface CB itself, but at the same time the cost for the cross-interconnection cabling will increase, which cost may become quite substantial for these large processes. At the same time, no other realizable possibility of connection exists with the technique described above. For connection of more complex, substantially analog, transducers and a development of so-called field buses is in process, where the transducers communicate directly with the computer. However, this is applicable only to expensive and complex transducers and actuators.

There also exist on the market small interface modules with a function similar to that of the interface units on PCBs for mounting according to the above. These interface modules are intended to be fixed to the same type of mounting rails as the mentioned rails for terminal blocks. The interface modules are then connected by a so-called point-to-point connection, that is, no bus structure exists. There are also units which communicate with the computer by means of a parallel bus which is connected between each interface module via separate cabling, normally a flat cable, thus requiring a location of such interface modules side-by-side. In this way it is not possible to mix interface modules with ordinary standard terminal blocks on the mounting rail. The interface modules are of multi-channel design, and therefore several of the above-mentioned disadvantages remain. Nor has cross-interconnection (or marshalling) been eliminated. Process interface units are also used which are single-channel insulated and replaceable, but in that case these are located on a separate backplane and therefore the units cannot be placed together with standard terminal blocks, which entails several of the above-listed disadvantages also for these single-channel insulated units.

In a new development stage within this technical field with a possibility of designing flexible electronic system equipment, it is desirable with a location of interface units between the computer and extenal units in the form of transducers or actuators closer to the process with its transducers and actuators. This method then requires channelwise insulation, no separate voltage supply other than via the serial bus, as well as extended diagnostic and programming facilities. By a completely different solution to the problem with communication between different units in the process computer system, this is possible.

### SUMMARY OF THE INVENTION

The present invention relates to a process interface system according to claim 1 in which preferably single-channel modules based on compact IC technique are housed in terminal block-like blocks of the same type as standard terminal blocks for mounting rails. The single-channel modules are designed in few different versions, which are programmed during installation for their field of use as AI or AO interface unit and DI or DO interface unit, respectively, and for their voltage range. Each interface module communicates directly with the system computer via a serial bus in the form of electrically conducting paths applied to the mounting rail on which the respective interface module has been mounted. The modules are supplied with power also through conducting paths on the rail surface. Connection of transducers is carried out directly to the respective interface unit. Terminal blocks may be freely mixed with interface modules for, for example, voltage distribution to the transducers.

Communication between interface module and system computer takes place via a mounting rail with conducting paths described in the Swedish patent application No. 9002762-4, filed concurrently herewith.

The new process interface system entails a new way of moving out interface units closer to the different external members of the process, and of simplifying the connection of these external members to the respective interface unit by eliminating the need of cross-interconnection. Interface units realized in modular form communicate with the computer via a serial bus, which communication requires a cable with few conductors connected to each local group of modules and to the computer.

The blocks in which the process interface modules are housed are, in external appearance, designed as terminal blocks of a similar type as ordinary standard terminal blocks intended for mounting on mounting rails. Since these modules in the form of terminal blocks are provided with contacts which are connected to the conducting paths of the mounting rail, these modules have been given the possibility to communicate with the system computer. Communication with the system computer is achieved via a serial bus, which requires at least one of the conducting paths in the bottom of the mounting rail.

Depending on the degree of integration, two different types of I/O modules may be required, one for the whole spectrum of digital signals within the relevant industrial equipment, and another for the most frequently used analog signal types within industrial activity. Typical types of signals are described in, for example, the IEC document 65A (Central Office) 21 from "Technical Committee No. 65" comprising "Industrial process measurement and control system considerations". As an example, it may be mentioned that four different standard I/O modules according to the invention cover almost 100% of the need of conceivable I/O interface units, whereas the corresponding need of different multi-channel CBs in the prior art described above amounts to over 50. The types of signals which are not covered by the standard modules in this invention may be converted in a separate signal converter. Another way is to construct a special module according to hybrid technology with standard components.

The possibility of realizing the small integrated interface modules is achieved by the use of single-channel insulated units, in which insulation, communication and power supply are combined in a discrete modularized unit with a very far-reaching integration in silicon-based electronics.

Standard terminal blocks for mounting on mounting rails may be mixed freely with the I/O modules on the mounting rail unless they somehow short-circuit the electrically conducting communication paths for these I/O modules. These terminal blocks may be necessary or desirable for extension of connection and distribution variants during installation of a process control system.

Each I/O module may be freely connected to or removed from the system under operating conditions. In addition, modules of the same type are mutually replaceable.

If in an interface system the need of I/O modules is greater than what can be accomodated on one mounting rail, several mounting rails may be connected to one another in a group. This is accomplished with a special communication unit in the form of a special module, which functions as termination on the mounting rail and which, in addition, communicates with the adjacent mounting rail within the group. Within each group of at least one mounting rail, there must also be a communication and current supply unit, also this unit being mounted on the mounting rail as a terminal block. This communication and current supply unit, hereinafter called SBC unit, constitutes an interface between a field bus which is in contact with the computer system of the process and the serial bus for short-distance communication within a group of I/O modules.

By a communication PCB in the computer part of the process system, each I/O module is scanned cyclically via communication on the field bus. Each individual I/O module has its own address, which the communication unit in the computer part senses during communication. In addition, each type of I/O module has a unique identification code.

As already mentioned, in principle only two different types of I/O modules in the process interface system are employed, one for digital and one for analog connections to external members. These two different I/O modules comprise circuits for the serial communication between the module and the system computer, circuits for signal, current and voltage adaptation, for cable supervision of possible faults in the cabling between the transducer and the I/O module, cable diagnostics, insulation and EMI barrier, protective devices against connection of incorrect signal types and, in addition, a circuit for internal temperature supervision.

The I/O modules are individually insulated and short-circuit proof. They are not capable of repairing but are discarded in case of malfunction. In addition, the manufacture of modules is characterized by low cost and simple production.

### BRIEF DESCRIPTION OF THE DRAWINGS

Figure 1 shows the principle of a modularized process interface system according to the invention and the communication of this system with a system computer.

Figure 2 schematically illustrates the external design of an I/O module and its mounting on a mounting rail.

Figure 3 schematically illustrates the internal block structure of an I/O module according to the invention.

Figure 4 shows how an interface system may be varied as required by being completely flexibly adapted to its function with the aid of optional combinations of I/O modules and terminal blocks.

Figures 5 and 6 schematically show the different circuits in the form of blocks for the internal configuration of a digital and an analog I/O module, respectively.

### DESCRIPTION OF THE PREFERRED EMBODIMENTS

With reference to the above-mentioned figures, a preferred embodiment of the present invention will be described.

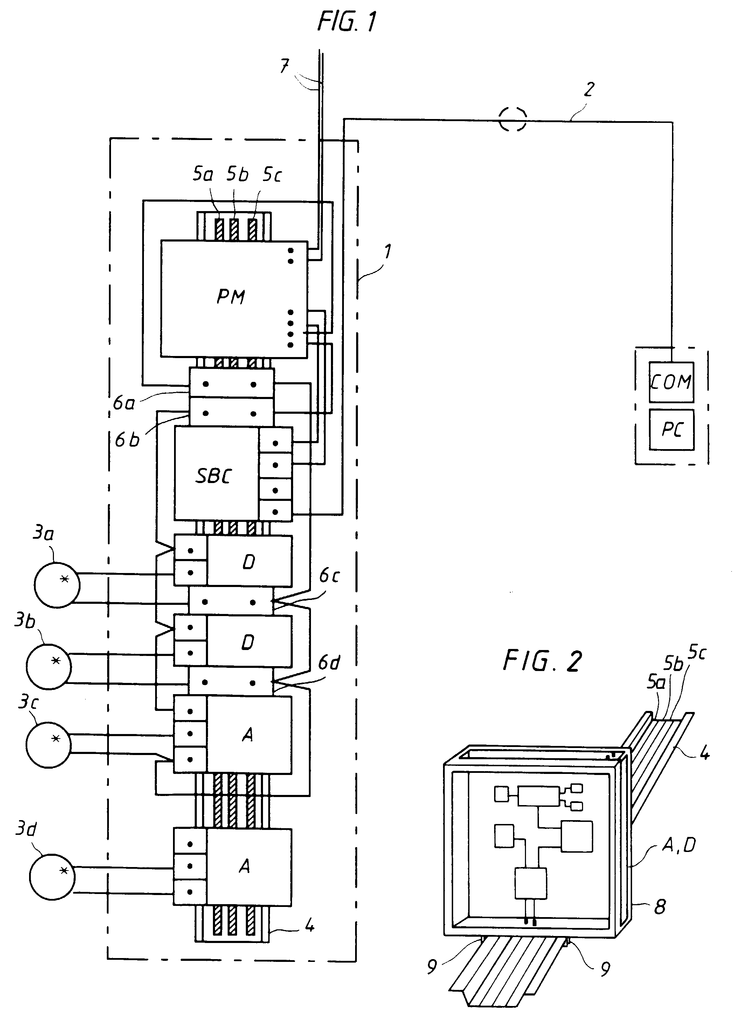

Figure 1 illustrates a system computer PC, which communicates with a process interface unit 1 through a communication unit COM via a field bus 2. The system computer PC is programmed with data for supervision or control of a process and communicates via the process interface unit 1 with external transducers, designated 3a, 3b, 3c etc. in the figure.

The process interface unit 1 comprises at least one mounting rail 4 and terminal blocks of various kinds mounted thereon, which will be described below.

A mounting rail 4 of standard type, for example according to DIN standard EN 50022-35*7.5, has been provided with electrically conducting paths 5a, 5b, etc., which are electrically insulated from one another and from the metal frame, if any, of the mounting rail. The conducting paths 5a, 5b, 5c etc. extend along the mounting rail, for example as shown in the figure. Another location of the conducting paths is fully feasible. As an alternative, these paths may also be located on the flanges of the rail. The conducting paths 5a-5c may, for example consist of insulating thin board, on which the conducting paths are applied in the form of thin electrically conducting layers, the board being located on the surface of the mounting rail 4 as a backplane to the mounting rail.

On the mounting rail 4, terminal blocks of various types may be mounted by snapping them onto or at the flanges of the mounting rail. Normally, standard terminal blocks are utilized in connection with connection work and installations for interconnection or connection of electrical equipment. Such standard terminal blocks are here designated with reference numerals 6a, 6b, 6c, 6d. These terminal blocks are used here only as connection and distribution terminal blocks and cannot normally communicate with the other terminal blocks or other equipment via the conducting paths on the mounting rail.

On the mounting rail, which is normally designed as a rail with flanges, digital and analog I/O modules D, A are also mounted. These I/O modules have an outer casing which gives the I/O modules a terminal block-like appearance according to Figure 2. The intention is also that the I/O modules should be handled in the same way as the above-mentioned standard terminal blocks, that is, that the modules are easily snapped onto the mounting rail. Besides being provided with connecting contacts for external transducers and for possible current and voltage connections, these modules are also provided on the underside with a number of contact members. When such an I/O module is mounted on the rail, these contact members on the I/O modules will engage with any of the conducting paths on the mounting rail 4, the conducting path or paths concerned then acting as electric connection with other electric units outside the I/O module.

The unit designated PM constitutes a current supply unit, which receives fed-in power via the cables 7. The current supply unit PM, also called current supply device, delivers the desired voltage, primarily to the transducers or the actuators but also to a communication unit SBC for further distribution out via the bus structure in the rail to the terminal blocks D and A. Depending on the power consumption of the external members 3, also the current supply device PM may be placed on the rail 4 in the same way as the terminal blocks.

A communication unit SBC is mounted on the same mounting rail 4 as the I/O modules and insulates and distributes voltage supply to these. This communication unit SBC receives or delivers data from or to the I/O modules. The data communication takes place in serial form within the process interface unit 1. The unit SBC acts as an interface between the communication unit COM of the process computer PC and the internal serial communication of the process interface unit. With the aid of the communication unit COM, the computer PC of the process interface system cyclically scans each connected I/O module D, A via the field bus 2. Each module connected to the rail 4 has been given its own identification code in the form of a communication address, which is attended to in connection with installation of the system, when each installed I/O module is programmed for its task. Alternatively, the address of the I/O module may be assigned to it by a selection mechanism, which utilizes selected signals dedicated to each I/O module, which signals are generated in the communication unit SBC, or a ramp may select the individual I/O modules. The storage of the communication address takes place, for example, in the EEprom of the respective I/O module. By the described communication, a direct communication between the respective I/O module and the system computer is made possible.

Figure 2 shows the external design of a digital or analog interface module D, A according to the invention. It also shows how the IC circuits of the I/O module are integrated in its encapsulation 8, which gives the module an appearance which resembles that of a standard terminal block for mounting rails of the above-mentioned kind. The figure also shows how the I/O module D, A is fixed to a mounting rail 4. The snap-in members 9, which lock the I/O module to the rail 4, are also indicated on the underside of the module. A number of conducting paths 5a-5c are located in the bottom of the mounting rail 4. These conducting paths constitute conductors for connection to the I/O module.

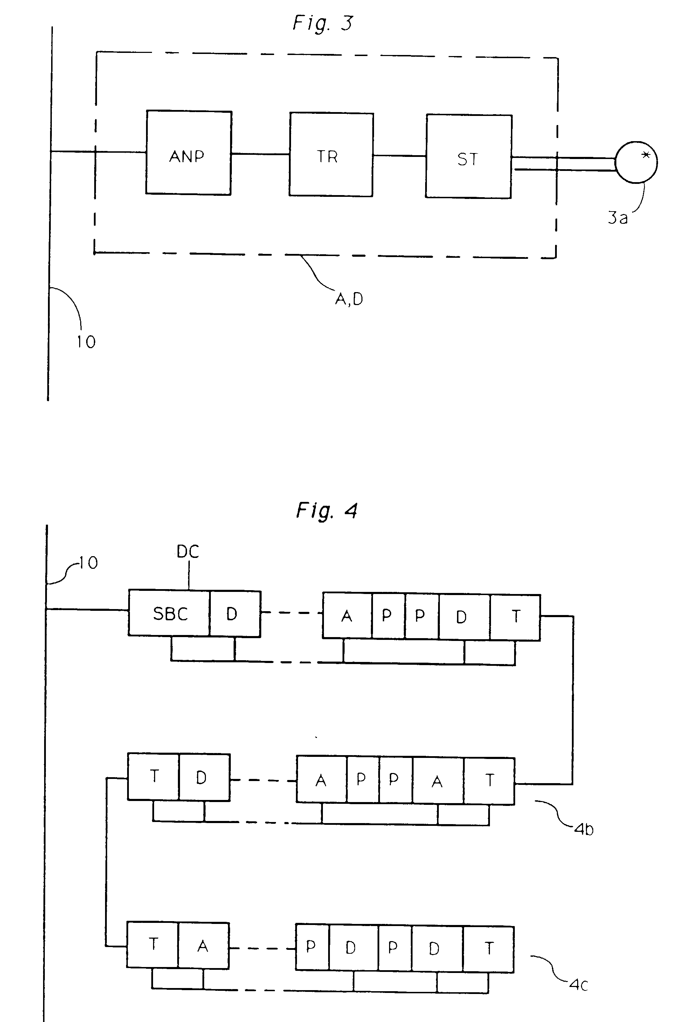

The mainly two different types of I/O modules D, A are illustrated in Figure 3, in which the interiors of the modules are schematically shown in block structure form. These blocks are identical in every way except with respect to the last block ST, which is different because of the function of the I/O module as analog or digital interface unit.

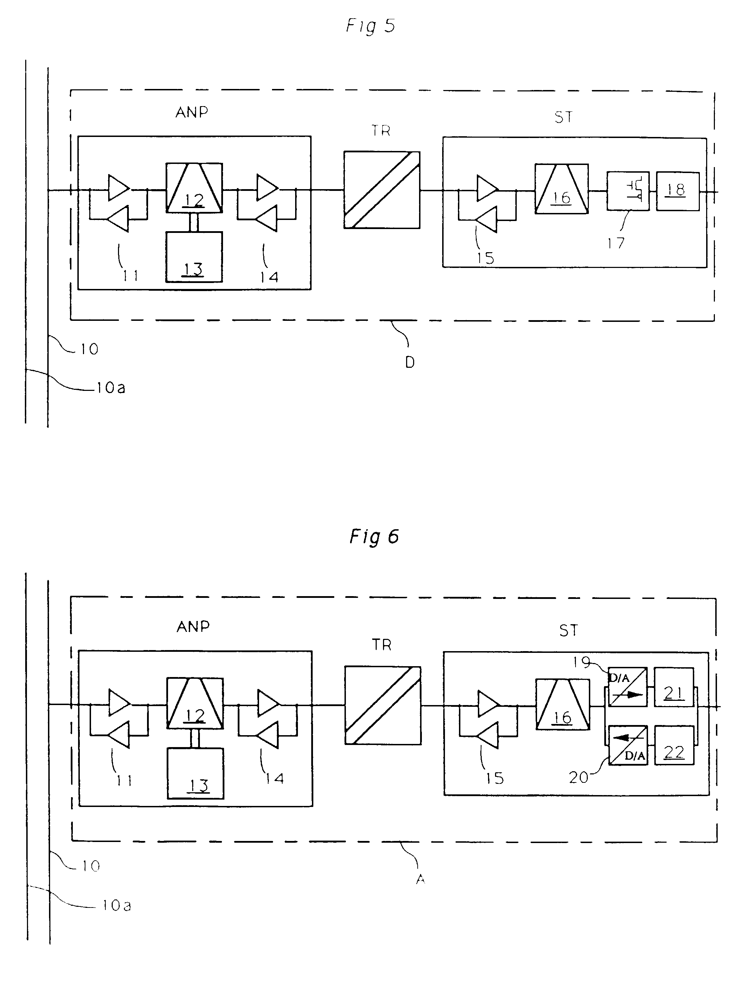

The first block in each I/O module consists of a communication interface unit ANP, which adapts received signals to a serial communication link 10, which is constituted by one of the conducting paths 5a-5c on the mounting rail 4. The unit ANP also has programmed into it the internal address to the respective module, watch functions for handling faults in case of failing communication, voltage supply of the unit TR, and filter functions. The power supply of the I/O module is achieved via the conductor 10a realized by a conducting path 5a-5c on the mounting rail 4. Figures 5 and 6 illustrate the interface unit ANP in a more detailed block diagram. In this, 11 designates a bus interface, 12 designates a protocol converter, 13 designates the above-mentioned circuit with watch functions, a so-called watchdog circuit, and 14 designates a communication interface and power supply member.

The block TR is required for insulation between the communication unit ANP and the signal conversion block ST. In the block TR, power between the units ANP and ST is also transmitted. In addition to these functions, the unit TR also constitutes a communication link for signal transmission between the ST block and the communication unit ANP, as well as an insulation and EMI barrier. In its simplest design, these functions are achieved by a transformer realizing the function of the TR block.

The signal conversion between the external members 3a-3c connected to the I/O module is realized in the signal conversion unit ST. The connected external members transmit or receive signals of quite different forms and voltage levels than what is a suitable form and level for communication with the system computer. Known technique for signal conversion between analog and digital signals is then utilized in the unit ST. For connection of the external members 3, the I/O modules D, A are equipped with contact devices for incoming or outgoing signals and for connection to external drive voltages. The possibility of the latter connection of external drive voltages applies only to analog I/O modules A and only when these operate with outgoing signals.

Drive voltages to the actual internal electronics in the I/O module are delivered thereto via the conducting paths 5 on the mounting rail 4. The contact devices for connection of external members are of the same type as on ordinary standard terminal blocks. The internal block structure for the unit ST is shown for a digital I/O module in Figure 5 and for an analog I/O module in Figure 6. In the latter figures, 15 designates a communication interface and power feeder of the same type as the block 14. A protocol converter and analog control unit 16 is also used here. In the digital variant of an I/O module D, the block 16 communicates with a MOSFET 17, which together with a unit for voltage and current sensing, in the same block, functions as a switch and/or current generator. The last unit in the chain is a protective unit 18, which provides protection for the electronics in the I/O module against external disturbances connected to the I/O module.

An analog I/O module A differs from a corresponding digital module D by the blocks 19 - 21 replacing the blocks 17 and 18. The blocks 19 and 20 are built up as conventional D/A converters and A/D converters, respectively, which are utilized according to the need depending on which external members are connected to the I/O module in question. The circuit 21 is a buffer and protective circuit. The circuit 22 is a buffer and current-voltage converter.

The field bus 2, which constitutes the serial bus communication between the system computer PC and the process interface unit 1, comprises, for example, a shielded two-strand conductor. This can be regarded as a great advantage with a process interface system of the kind described. The need of cross-interconnections is eliminated. In addition, it is easy to realize the advantage with the I/O modules consisting of single-channel units, which are easily mounted, replaced and placed at an optional location on the mounting rail 4. The channelwise insulation results in greater immunity to disturbance and in further simplified installation. The existing signal levels of existing units, which are not directly connectible to the field bus, can thus be connected in an inexpensive and simple manner.

In those cases where the space on an individual mounting rail is too limited because all I/O modules D, A, which are necessary for the process interface unit 1, cannot be accomodated on one and the same mounting rail, the number of mounting rails included in the process interface unit may be extended, as shown in Figure 4. To make possible this extension of the number of rails 4 in the process interface unit 1, bus expansion units T are arranged at the ends of additional rails, which units T attend to the serial communication with the I/O modules of adjacent mounting rails. Figure 4 illustrates these bus expansion units T at the ends of additional mounting rails 4b, 4c. Between these units T, I/O modules D, A alternating with standard terminal blocks P occur. In the same way as with a process interface unit with only one mounting rail 4, a combined communication and current supply unit SBC is provided with external drive voltage DC for the whole group of modules A, D on the extended number of rails 4.

The above described system for installation, connection and construction of an electronic system, in which modularized units communicate via a serial link 2 on a mounting rail, may be applied to other electronic equipment and is not, of course, linked to industrial process interface systems only, but can be used whereever a simplified communication and connection method with a superordinate electronic device is desirable.

The number of conducting paths on a mounting rail is not in any way fixed to that stated in the embodiment described but can be varied freely depending on the desired function.

## Claims

1. A process interface system comprising a system computer (PC), external members (3a, 3b, 3c) and interface units between these, **characterized in that** the interface units in the system for necessary communication between the computer (PC) and the external members (3a, 3b, 3c) of the system are housed in terminal block-like modules (D, A), which modules are mounted on a mounting rail (4) and communicate with the computer (PC) via electrically conducting paths (5a, 5b, 5c) applied to the surface of the mounting rail (4) or applied to a separate backplane placed on a surface of the mounting rail (4).

2. A process interface system according to claim 1, **characterized in that** the modules (D, A) can be freely mixed with standard terminal blocks (P) on the same mounting rail (4).

3. A process interface system according to claim 1, **characterized in that** the interface units in the form of modules (D, A) are of single-channel design and individually insulated and that external members (3a, 3b, 3c) may be connected directly to the respective module.

4. A process interface system according to claim 3, **characterized in that** the module (D, A) is programmed for its field of use as input or output and for its field of operation.

5. A process interface system according to claim 4, **characterized in that** the modules (D, A) communicate directly with the computer (PC) via a serial bus, which consists of one or more conducting paths (5a, 5b, 5c) on the surface of the mounting rail (4) or on a backplane placed on a surface of the rail (4).

6. A process interface system according to claim 5, **characterized in that** the modules (D, A) communicate with the computer via a communication unit (SBC) on the mounting rail (4).

7. A process interface system according to claim 5 or 6, **characterized in that** the interface unit in the respective module (D, A) comprises units for communication (ANP) via the serial bus (10), insulation (TR), power supply and signal conversion (ST).

8. Process interface system according to claim 1, **characterized in that** the number of mounting rails (4) in the system can be extended by placing bus expansion units (T) at connected rails (4) being connected to and communicating with one another.

9. A process interface system according to claim 1, **characterized in that** transducers/actuators as external members in the process and/or modules (D, A) are supplied with power via supply devices (PM) on or at the side of the mounting rail (4).

10. A process interface system according to claim 9, **characterized in that** the interface units in the modules (D, A) are supplied with current and voltage via the conducting paths (5a, 5b, 5c) and via an insulation element (TR).

11. A process interface system according to claim 1, **characterized in that** the modules (D, A) are provided with contact members which are brought into electrical connection with the conducting paths (5a, 5b, 5c) on the surface of the mounting rail (4) when mounting a module (D, A) on a mounting rail.

12. A process interface system according to claim 1, **characterized in that** the modules (D, A) comprise fixing means (9) by which the modules are snapped onto the mounting rail (4) when mounting modules on the rail (4).

13. A process interface system according to claim 7, **characterized in that** the modules (D, A) comprise circuits for diagnostics, cable monitoring, watchdogs (13), individual insulation and local filtering of transducer signals.

## Patentansprüche

1. Prozeß-Interface-System mit einem Systemcomputer (PC), äußeren Gliedern (3a,3b,3c) und zwischen dem Systemcomputer (PC) und den äußeren Gliedern (3a,3b,3c) vorhandenen Interface-Einheiten, **dadurch gekennzeichnet**, daß die für die notwendige Kommunikation zwischen dem Computer (PC) und den äußeren Gliedern (3a,3b,3c) erforderlichen Interface-Einheiten des Systems in anschlußblock-ähnlichen Moduln (D,A) untergebracht sind, welche Moduln auf einer Befestigungsschiene (4) montiert sind und mit dem Computer (PC) über elektrische Leiterpfade (5a,5b,5c) verbunden sind, die auf der Oberfläche der Befestigungsschiene (4) oder auf einer separaten Platte angebracht sind, welche Platte ihrerseits auf einer Fläche der Befestigungsschiene angebracht ist.

2. Prozeß-Interface-System nach Anspruch 1, **dadurch gekennzeichnet**, daß die Moduln (D,A) auf derselben Befestigungsschiene (4) mit Standard-Anschlußblöcken beliebig gemischt werden können.

3. Prozeß-Interface-System nach Anspruch 1, **dadurch gekennzeichnet**, daß die als Moduln (D,A) vorliegenden Interface-Einheiten als Einzelkanäle mit individueller Isolation aufgebaut sind und daß äußeren Glieder (3a,3b,3c) direkt an den entsprechenden Modul anschließbar sind.

4. Prozeß-Interface-System nach Anspruch 3, **dadurch gekennzeichnet**, daß der Modul (D,A) entsprechend seiner Verwendung als -Eingang oder Ausgang sowie entsprechend seinem Anwendungsgebiet programmiert ist.

5. Prozeß-Interface-System nach Anspruch 4, **dadurch gekennzeichnet**, daß die Moduln (D,A) mit dem Computer (PC) direkt über einen seriellen Bus verbunden sind, der aus einem oder mehreren Leiterpfad/Leiterpfaden (5a,5b,5c) auf der Oberfläche der Befestigungsschiene (4) oder auf einer Platte, die ihrerseits auf einer Fläche der Schiene (4) angebracht ist, besteht.

6. Prozeß-Interface-System nach Anspruch 5, **dadurch gekennzeichnet**, daß die Moduln (D,A) mit dem Computer über eine Verbindungseinheit (SBC) auf der Schiene (4) in Verbindung stehen.

7. Prozeß-Interface-System nach Anspruch 5 oder 6, **dadurch gekennzeichnet**, daß die Interface-Einheit in dem entsprechenden Modul (D,A) Einheiten zur Kommunikation (ANP) über den seriellen Bus (10), zur Isolation (TR), zur Energieversorgung und zur Signalwandlung enthält.

8. Prozeß-Interface-System nach Anspruch 1, **dadurch gekennzeichnet**, daß die Anzahl der im System vorhandenen Befestigungsschiene (4) durch Buserweiterungseinheiten (T) an den Schienen (4) vergrößert werden kann, über welche Buserweiterungseinheiten (T) die Schienen miteinander verbunden sind und miteinander kommunizieren.

9. Prozeß-Interface-System nach Anspruch 1, **dadurch gekennzeichnet**, daß äußere Glieder bildende Geber/Stellglieder in dem Prozeß und/oder Moduln (D,A) über ein Speiseglied (PM) mit Energie versorgt werden, welches auf der Befestigungsschiene (4) oder an ihrer Seite angeordnet ist.

10. Prozeß-Interface-System nach Anspruch 9, **dadurch gekennzeichnet**, daß die Interface-Einheiten in den Moduln (D,A) über Leiterpfade (5a,5b,5c) und über ein Isolierelement (TR) mit Strom und Spannung versorgt werden.

11. Prozeß-Interface-System nach Anspruch 1, **dadurch gekennzeichnet**, daß die Moduln (D,A) mit Kontaktgliedern versehen sind, die beim Montieren eines Moduls (D,A) auf der Befestigungsschiene (4) mit den Leiterpfaden (5a,5b,5c) auf der Oberfläche der Befestigungsschiene (4) elektrisch verbunden werden.

12. Prozeß-Interface-System nach Anspruch 1, **dadurch gekennzeichnet**, daß die Moduln (D,A) mit Befestigungsvorrichtungen (9) versehen sind, mit welchen die Moduln beim Montieren auf der Befestigungsschiene (4) einrastend (einschnappend) befestigt werden können.

13. Prozeß-Interface-System nach Anspruch 7, **dadurch gekennzeichnet**, daß die Moduln (D,A) Schaltkreise zur Diagnose, zur Kabelüberwachung, Überwachungskreis (13), zur individuellen Isolierung und zur lokalen Filterung von Gebersignalen enthalten.

## Revendications

1. Système d'interface de processus comprenant un ordinateur de système (PC), des éléments (3a, 3b, 3c) externes et des unités d'interface entre ceux-ci, caractérisé en ce que les unités d'interface dans le système destinées à la communication nécessaire entre l'ordinateur (PC) et les éléments (3a, 3b, 3c) externes du système sont logées dans des modules (D, A) terminaux analogues à des blocs, ces modules étant montés sur un rail (4) de montage et communiquant avec l'ordinateur (PC) par l'intermédiaire de pistes (5a, 5b, 5c) conductrices électriquement qui sont appliquées à la surface du rail (4) de montage ou appliqués à un fond de panier distinct placé sur une surface du rail (4) de montage.

2. Système d'interface de processus suivant la revendication 1, caractérisé en ce que les modules (D, A) peuvent être mélangés librement à des blocs (P) de terminaux standard sur le même rail (4) de montage.

3. Système d'interface de processus suivant la revendication 1, caractérisé en ce que les unités d'interface sous la forme de modules (D, A) sont de conception à canal simple et individuellement isolées et en ce que les éléments (3a, 3b, 3c) externes peuvent être connectés directement au module respectif.

4. Système d'interface de processus suivant la revendication 3, caractérisé en ce que le module (D, A) est programmé pour son domaine d'utilisation en tant que entrée ou sortie et pour son domaine de fonctionnement.

5. Système d'interface de processus suivant la revendication 4, caractérisé en ce que les modules (D, A) communiquent directement avec l'ordinateur (PC) par l'intermédiaire d'un bus série qui consiste en une ou plusieurs pistes (5a, 5b, 5c) conductrices sur la surface du rail (4) de montage ou sur un fond de panier placé sur une surface du rail (4).

6. Système d'interface de processus suivant la revendication 5, caractérisé en ce que les modules (D, A) communiquent avec l'ordinateur par l'intermédiaire d'une unité (SBC) de communication sur le rail (4) de montage.

7. Système d'interface de processus suivant la revendication 5 ou 6, caractérisé en ce que l'unité d'interface dans le module (D, A) respectif comporte des unités pour la communication (ANP) par l'intermédiaire du bus (10) série, pour l'isolation (TR), pour l'alimentation en énergie et pour la conversion (ST) de signal.

8. Système d'interface de processus suivant la revendication 1, caractérisé en ce que le nombre de rails (4) de montage dans le système peut être étendu en plaçant des unités (T) d'expansion de bus aux rails (4) connectés qui sont connectés les uns aux autres et qui communiquent les uns avec les autres.

9. Système d'interface de processus suivant la revendication 1, caractérisé en ce que des actionneurs/transducteurs, en tant qu'éléments extérieurs dans le processus, et/ou des modules (D, A) sont alimentés en énergie par l'intermédiaire de dispositifs (PM) d'alimentation sur le rail de montage ou à côté du rail (4) de montage.

10. Système d'interface de processus suivant la revendication 9, caractérisé en ce que les unités d'interface dans les modules (D, A) sont alimentés en courant et tension par l'intermédiaire des pistes (5a, 5b. 5c) conductrices et par l'intermédiaire d'un élément (TR) d'isolation.

11. Système d'interface de processus suivant la revendication 1, caractérisé en ce que les modules (D, A) sont munis d'éléments de contact qui sont amenés en connection électrique avec les pistes (5a, 5b, 5c) conductrices sur la surface du rail (4) de montage, lorsqu'un module (D, A) est monté sur un rail de montage.

12. Système d'interface de processus suivant la revendication 1, caractérisé en ce que les modules (D, A) comportent des moyens (9) de fixation par lesquels les modules sont fixés par encliquetage sur le rail (4) de montage, lorsque l'on monte des modules sur le rail (4).

13. Système d'interace de processus suivant la revendication 7, caractérisé en ce que les modules (D, A) comportent des circuits de diagnostic, de surveillance de câbles, de chiens de garde (13), d'isolation individuelle et de filtrage local de signaux de transducteur.
